# EUROPEAN PATENT APPLICATION

(11) **EP 2 037 581 A1**
(43) Date of publication of application: **18.03.2009**
(21) Application number: 07788581.2
(22) Date of filing: 07.06.2007
(51) Int. Cl.: H03K 17/94, H01H 47/24, H03K 17/79, H05B 37/02, G02B 6/35, H02J 13/00

(54) **INTEGRATED ELECTRICAL-INSTALLATION MANAGEMENT SYSTEM**

(30) Priority: 09.06.2006 ES 200601554
(71) Applicant: Mecel, S.L., 46910 Sedavi Valencia (ES)
(72) Inventor: FELIU MINGARRO, Carlos, 12006 Castellon (ES); DIEGUEZ RAMIREZ, Amalia, 12006 Castellon (ES); QUIJANO LOPEZ, Alfredo, 46980 Valencia (ES); MAYORGA RUBIO, Pedro Miguel, 46980 Valencia (ES); SILVA MORENO, Gonzalo, Baynat s/n (ES)
(74) Representative: Ungria Lopez, Javier
(86) International application number: PCT/ES2007/000333
(87) International publication number: WO 2007/144439

(57) **Abstract**

The system is based on actuator elements, such as switches (1) for activating an electrical element (6), are connected to a corresponding conventional wiring (2), by means of optical fiber cables (3) that constitute the actual switches (1), causing the commands for actuating the switches to be transmitted by means of light pulses to the wiring (2), specifically to the respective control box (7) electrically connected to the wiring (2), there being two independent zones (4 and 5), the first of these having an electrical voltage and being inaccessible to the user and the other corresponding to the zone where the switches (1) are located, which has no voltage. The system can be applied for use in any type of enclosure and especially in those with electrical safety requirements.

## Description

### OBJECT OF THE INVENTION

As stated in the title of this descriptive specification, the present invention relates to an integrated electrical-installation management system which combines the use of existing electrical wiring with signal transmission means based on optical fiber cable, permitting the zone or area of location of the switches to be isolated with respect to the zone corresponding to the conventional electrical circuit, preventing any risk of electrical conduction.

A further object of the invention is the incorporation of lighting control means in combination with a control panel, the two communicating with each other by means of a field bus.

### BACKGROUND OF THE INVENTION

Present-day electrical installations are carried out by means of the connection of different elements (switches, circuit breakers, etc.) with copper wiring, in other words with conductors of various diameters depending on the type and voltage of the installation, in such a way that the installations have to be designed in compliance with the requirements established in the electrotechnical regulations for low voltage, primarily in relation to areas of prohibition in damp spaces such as bathrooms and kitchens.

Given that there exists an electrical voltage in all actuator elements, under these conditions there can exist a risk of electrocution due to a fault or malfunctioning of them, and there exist limitations on the location when it comes to designing installations in order to guarantee safety for the users.

In conventional installations, the electrical conduction wires run from the main voltage lines located in the upper part of the enclosure as far as the actuators, with the consequent risk that the user can receive an electrical discharge due to a fault or malfunctioning of said electrical actuators which, as has been said earlier, correspond to switches, circuit breakers, etc.

### DESCRIPTION OF THE INVENTION

The system of the invention solves the problem referred to above, basing itself on the fact that the switches zone is connected to the installation of the conventional electrical circuit by means of optical fiber cables, in such a way that the actuation orders are transmitted by means of light pulses for activation of the device to connect or disconnect, for example an electric lamp, so that, unlike conventional installations, the electrical conduction wiring do not run from the main voltage lines as far as the switches zone since, on the basis of optical fiber cables, two zones or areas are demarcated, one corresponding to the said switches zone, without voltage of any kind, and the other corresponding to the conventional electrical installation or circuit, which is inaccessible to the user, thereby preventing the possibility of an electric shock.

In the proposed system of the invention, in order to manage the light signal received from the switch, the corresponding control box is fitted with a generation/detection circuit, which transmits the orders to the actuator for it to effect the connection/disconnection of the electrical device.

It also includes electronics that allow any number of control boxes to be connected together, permitting management of the device from different points of the enclosure, without the need for additional connections among the switches.

In relation to the switches in themselves, whey will be able to consist simply of two optical fiber cables that can be parallel, concentric or have any other arrangement, or they can consist of another device capable of producing reflection of the light beam and its return to the detector. In either case, it permits the use of electro-mechanical switches to be done away with, eliminating the problems of wear of the mechanism and the risks of sparks being generated in the electrical contacts.

The optical fiber cables can be used as a light indicator of the position of the switches in the dark, the cable in each case being situated in such a way that it descends from the conventional electrical installation, generally located in the upper part of the enclosure, via the outside of the vertical and/or horizontal surfaces, or being embedded in their interior by means of guide ducts.

The system permits the location of switches or detectors in any position of the installation, being specifically suitable in those enclosures with damp areas, explosive atmospheres, etc.

Regardless the safety advantages mentioned earlier, by means of being materialized with a small volume and with an absence of electrical conduction, the system of the invention permits the installation of wiring by means of a guide of depth even less than 5 mm, from the electrical circuit In the upper part of the enclosure as far as the zone of location of the switch, both on the outside and by embedding in the vertical or horizontal surfaces of the enclosure, as stated above.

Given that no connections are required between the switches for switching devices of different positions, it is possible to enlarge the installation by means of new switches without any need to carry out works in the enclosure, simply by installing the optical fiber cables running downwards from the conventional electrical wiring as far as the position of the switches.

Equally, by means of the said electronic management system of the control boxes, the switches can be modified, altering the action effected or the device to control without modifying the wiring for the installation.

The system is furthermore complemented with lighting control means in combination with a control panel, the communication between the control box or boxes and the said lighting control means, as well as with the control panel, being set up by means of a field bus.

The said lighting control means are based on a series of stages which correspond to:
1.- A stage for obtaining a digital value corresponding to the ambient light level, this stage comprising an analog input for a light sensor, along with means for discretizing said analog input and achieving a value in a digital representation.
2.- A stage that comprises means for a signal with just two possible values of voltage coming from a presence detector.
3.- A stage that comprises a light intensity regulator for incandescent lamps.
4.- A stage that comprises a light intensity regulator for electronic ballasts for fluorescent lamps.
5.- A stage for regulating the lighting which takes the value of the ambient light obtained in stage 1 as the variable to control, having as the actuation variable an output in digital representation which is used for establishing the output value of stages 3 and 4.
6.- A stage that comprises a communication bus with the control panel.

In said system or means of control of lighting, the interface between the electric circuit for the lighting and the user is solved by means of optical fiber, providing greater safety, aesthetics and hygiene, with the particular feature that, on the basis of the said control means, it is possible to monitor, control and configure the installation from the actual control panel, the latter being able to include a PC with microprocessor, volatile and non-volatile memory with a real time operating system, along with the algorithms for configuration, monitoring, control, maintenance and management of the electrical consumption of the installation. Said means are communicated with an electronic card where the bus controller is implemented, being complemented with a touch-sensitive graphic screen as means of interaction with the user, along with a power supply source and corresponding housing.

The said control panel will permit the flexible configuration of the electrical installation since, once the control boxes have been connected to the communication bus, it will be possible to associate the optical fiber switch and stage 2 of any control box with stages 3 and 4 of any other control box.

As well as the means commented on, the control panel will also include:
- A timer for making it possible to implement delays for switching off the lamp connected to stages 3 and 4, this timer also being able to be used for implementing a "sleep" function, in other words, for disconnecting said lamp within an established time from when the "sleep" order is given.
- An internal clock and means for synchronizing it with the present time, in order to permit a programming of the time to be created allowing the values of stages 3 and 4 to be included, these values being able to have a different switching-on value for each period of time.
- Means for permitting the user to have memorization/preselection of a combination of lighting with variable power regulation for each lamp, in such a way that the creation and reproduction of scenes will take place from the actual control panel, with stages 3 and 4 being selected in it for inclusion in the scene, along with the level of switching-on for each of them, which can be one existing at that instant or it will be possible to change it.
- Means for manual monitoring and control of the electrical installation from the actual control panel, said means being able to be materialized in a touch-sensitive screen from which it is possible to configure the system, and to monitor and act on the value of stages 3 and 4 of all the control boxes.
- Means of communication for TCP/IP connection to a local network and the Internet, permitting the remote configuration, monitoring and control from any part of the world.
- Means of storage of the number of switchings and number of hours switched on for all lamps connected to stages 3 and 4 of the control boxes, which permits preventive maintenance to be carried out on them, with the particular feature that the manager of the system will be able to use this information for replacing the lamps whose use and switchings exceed the life expectancy of them and which have lost a large part of their lighting efficiency.
- Finally, it can be said that for stages 3 and 4, the power of the lamps connected to them has to be stated, so that it is possible to extrapolate the lighting consumption on the basis of the number of hours switched on. This consumption will be able to consulted individually for each stage 3 and 4, and the total consumption of a selection of them will likewise be able to be seen.

### BRIEF DESCRIPTION OF THE DRAWINGS

In order to complement the description that is going to be made forthwith, and for a better understanding of the characteristics of this invention, this specification is accompanied by a set of drawings on the basis of which the innovations and advantages of the electrical-installation management system will be able to be more easily comprehended.
**Figure 1****.-** Shows the block diagram of an installation for two switches, defining a basic form of embodiment of the integrated system forming the object of the invention.
**Figure 2****.-** Shows the block diagram of the stages corresponding to the lighting control means and the associated control panel.

### DESCRIPTION OF A PREFERRED EMBODIMENT

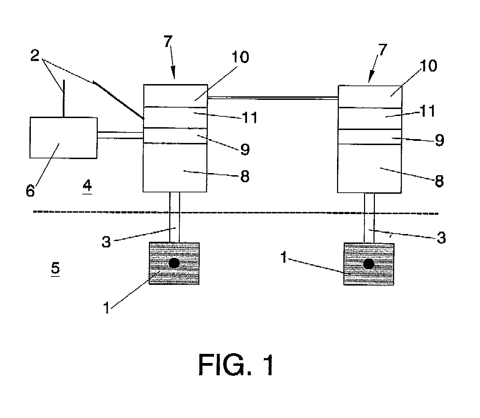

With figure 1 in view, the diagram of the installation can be seen for two switches represented and identified by means of reference 1, whose connection with the conventional electrical wiring 2 is effected by means of optical fiber cables 3, with two independent zones 4 and 5 being established, the first of these being connected to the said electric circuit 2, to which are electrically connected the corresponding control boxes 7 which are actuated by means of the switches 1 already mentioned, the control boxes 7 being connected to the electrical device 6, such as might be a lamp, whose activation is intended, all this in such a way that the only part accessible to the user, so that he or she can effect the activation/deactivation of said electrical device 6, is the optical fiber switch 1, or, putting this In another way, the low voltage elements remain beyond the reach of users, thereby avoiding the possibility of an electric shock.

In said figure 1, the electrical device 6 to be connected/disconnected, which receives the voltage from the electrical wiring 2, is connected to the corresponding actuator 9 provided in the control box 7 situated in connection with the electrical wiring, and therefore located in the zone 4, in such a way that, in order to manage the said light signal from the switch 1, via the optical fiber cables 3, in the actual control box 7, provision has been made for a light beam generation and detection circuit 8, which transmits the orders to the actuator 9 so that it can effect the connection/disconnection of the electrical device 6.

In that figure 1, the block 11 corresponding to a power supply source can likewise be seen, as can electronics 10 which permits management of different points without any need for additional connections between the switches 1.

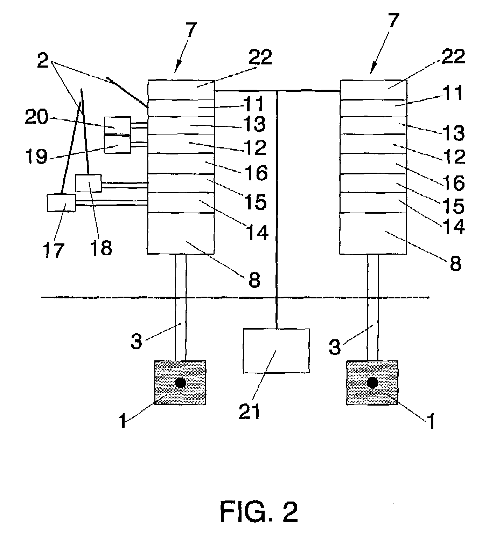

Figure 2 shows the bock diagram corresponding to the lighting control means that complement each control box 7, these means in each case consisting of a series of stages which are the following:
- Stage represented by the block 12, provided for obtaining a digital value corresponding to the ambient light level, said stage consisting of an analog input for a lighting sensor 19 and means for discretizing the analog input by means of A-D converters, obtaining a value in digital representation. The magnitude of the input can be a voltage proportional to the ambient light level or a current strength proportional to the ambient light level, there likewise existing a mode of implementation where the actual pick-up for the ambient light is included inside the equipment, and can consist of a photo-variable resistor.
- Stage represented by the block 13, which includes input means for a signal with just two possible values of voltage coming from a presence detector 20.
- Stage represented by the block 14, for output dimmer for incandescent lamps 17, with the aim of regulating their lighting intensity from between 0-100%. The output in this dimmer stage will consist of a voltage of between 0 and 100% of the mains voltage of the electrical installation. As is known, the dimmer corresponds to an intensity regulator.
- Stage represented by the block 15, for output dimmer for electronic ballasts for fluorescent lamps, with the aim of regulating their lighting intensity from between 0-100%. This output can consist of an analog voltage of between 1 and 10 volts in direct current or by means of the DALI digital lighting protocol.
- Stage represented by the block 18, as lighting regulator stage which takes the value of the ambient light obtained in stage 12 as the variable to control, and has as the actuation variable an output in digital representation which is used for establishing the output value of stages 14 and 15.
- Stage represented by the block 22, corresponding to a communication bus for communicating with the control panel 21. The protocol of said communication bus will be able to be an own protocol or a standard protocol, while the physical medium of communication will be able to be twisted pair, optical fiber, radiofrequency through the air, etc.

## Claims

1. **INTEGRATED ELECTRICAL-INSTALLATION MANAGEMENT SYSTEM,** which, being applicable in the connections between control boxes provided in the electrical wiring of an enclosure and elements such as switches, circuit breakers and similar, by means of which the connection/disconnection is effected of an electrical device, such as a lamp, controlled by one of said switches, is **characterized in that** it comprises optical fiber cabling (3) as means of connection between each switch (1) and the corresponding control box (7) fitted with the respective actuator (9), establishing two independent zones (4 and 5), the first of them corresponding to the conventional electrical wiring (2), insulated and inaccessible to the user, and the other zone (5) corresponding to the location of the actual switches (1) from which and via the optical fiber cables (3) corresponding light pulses are transmitted as far as the actual control box (7) electrically connected to the electrical wiring (2).

2. **INTEGRATED ELECTRICAL-INSTALLATION MANAGEMENT SYSTEM,** according to claim 1, **characterized in that** each one of the control boxes (7) via which the managing of the light signal is effected received from the zone of the switches (1) is provided with a light beam generation and detection circuit (8), which circuit (8) transmits the orders to the actuator (9) for the setting up of the connection/disconnection of the respective electrical device (6) which is intended to be activated; provision also having been made for electronics (10) which permits connection among themselves of any number of control boxes (7), permitting management from different points of the enclosure, without any need for additional connections among the switches (1).

3. **INTEGRATED ELECTRICAL-INSTALLATION MANAGEMENT SYSTEM,** according to the above claims, **characterized in that** the optical fiber cables (3) constitute the actual switches (1), being able to be materialized by two cables that are parallel or concentric, or in any other arrangement, and suitable for being constituted by any other device capable of producing reflection of the light beam and its return to the detection circuit.

4. **INTEGRATED ELECTRICAL-INSTALLATION MANAGEMENT SYSTEM,** according to the above claims, **characterized in that** the optical fiber cables (3) descend from the electrical wiring (2) generally located in the upper part of the enclosure, via the inside of vertical or horizontal surfaces, or embedded in their interior by means of appropriate guide ducts.

5. **INTEGRATED ELECTRICAL-INSTALLATION MANAGEMENT SYSTEM,** according to the above claims, **characterized in that** each control box (7) is complemented with lighting control means and with a control panel (21) that makes it possible to monitor, control, configure, maintain and manage the electrical consumption of the installation as a whole.

6. **INTEGRATED ELECTRICAL-INSTALLATION MANAGEMENT SYSTEM,** according to claim 5, **characterized in that** the lighting control means comprise an array of blocks corresponding to functional stages, there existing a first stage or block (12) intended for obtaining a digital value corresponding to the ambient light level, consisting of an analog input for a lighting sensor (19) and means for discretizing the analog input by means of converters, obtaining a value in digital representation; there existing a second stage represented by the block (13), which includes input means for a signal with just two possible values of voltage coming from a presence detector (20), furthermore including a stage represented by the block (14), as output intensity regulator for incandescent lamps (17), permitting their lighting intensity to be regulated from between 0-100%, also comprising a stage corresponding to the block (15), as output intensity regulator for electronic ballasts for fluorescent lamps (18), with the aim of regulating their lighting intensity from between 0-100%; comprising moreover a stage corresponding to the block (16), as lighting regulator stage which takes the value of the ambient light obtained in stage (12) as the variable to control, having as the actuation variable an output in digital representation which is used for establishing the output value of the stages (14 and 15); said means being complemented with a stage corresponding to the block (22), which constitutes a bus for communication with the control panel (21).

7. **INTEGRATED ELECTRICAL-INSTALLATION MANAGEMENT SYSTEM,** according to claims 5 and 6, **characterized in that** the control panel (21) comprises a PC with microprocessor, volatile memory, non-volatile memory for installation of a real time operating system and the algorithms for configuration, monitoring and control of the installation, being complemented with a touch-sensitive graphic screen as means of interaction with the user; with provision having been made for the said control panel (21) furthermore to include a timer for making it possible to implement delays for switching off the lamps connected to the stages (14 and 15), as well as for implementing a function for disconnecting said lamps within an established time: with the particular feature of furthermore including an internal clock for carrying out a programming of the time, means for the manual monitoring and control of the installation from the actual control panel, as well as means of communication for TCP/IP connection to a local network and the Internet, also including means of storage of the number of switchings and number of lamps on for all lamps connected to the stages (13 and 14) of the control box (7).
